# EUROPÄISCHE PATENTANMELDUNG

(11) **EP 2 866 041 A1**
(43) Veröffentlichungstag der Anmeldung: **29.04.2015**
(21) Anmeldenummer: 14188509.5
(22) Anmeldetag: 10.10.2014
(51) Int. Cl.: G01R 31/14, G01R 31/02, G01R 31/08, G01R 31/12, H02H 1/00

(54) **Messknoten, System und Verfahren zur Überwachung des Zustands eines Energieversorgungsnetzwerks**

(30) Priorität: 24.10.2013 DE 102013221666; 08.10.2014 DE 102014220421
(71) Anmelder: Power Plus Communications AG, 68167 Mannheim (DE)
(72) Erfinder: Veselcic, Marko, 67122 Altrip (DE); Lehmann, Josef, 79761 Waldshut-Tiengen (DE)
(74) Vertreter: Patent- und Rechtsanwälte Ullrich & Naumann

(57) **Zusammenfassung**

Die Erfindung betrifft ein Messknoten (1) zur Überwachung des Zustands eines Teilbereichs eines Energieversorgungsnetzwerks (7), insbesondere zur Detektion von Teilentladungen, wobei an dem Energieversorgungsnetzwerk (7) eine Netzspannung anliegt. Der Messknoten (1) umfasst ein Koppelnetzwerk (2), eine Filterschaltung (21) und eine Auswerteeinheit (22). Die Koppelschaltung (2) ist an das Energieversorgungsnetzwerk (7) ankoppelbar und zum Auskoppeln eines Störsignals aus dem Energieversorgungsnetzwerk (7) ausgebildet. Die Filterschaltung (21) ist mit dem Koppelnetzwerk (2) verbunden und erzeugt durch Bandpassfilterung aus dem Störsignal ein Messsignal. Dabei ist der Bandpass derart dimensioniert, dass das Messsignal zumindest eine für den Zustand des Energieversorgungsnetzwerks (7) repräsentative Komponente enthält. Die Auswerteeinheit (22) ist zur Analyse des Messsignals über einen Auswertezeitraum hinweg ausgebildet, wobei bei der Analyse der zeitliche Verlauf von zumindest Teilen des Messsignals relativ zu der Netzspannung ausgewertet wird und wobei die Analyse des Messsignals eine Bewertungsgröße für den Zustand des Teilbereichs des Energieversorgungsnetzwerks (7) liefert.

Es ist ferner ein System zur Überwachung des Zustands eines Energieversorgungsnetzwerks (7) offenbart. Das System umfasst eine Vielzahl von Messknoten (1), vorzugsweise die erfindungsgemäßen Messknoten, ein Weitbereichsnetzwerk und einen Server, der über das Weitbereichsnetzwerk mit den Messknoten (1) kommunizierend verbunden ist. Ferner ist ein entsprechendes Verfahren angegeben.

## Beschreibung

Die Erfindung betrifft ein System und ein Verfahren zur Überwachung des Zustands eines Energieversorgungsnetzwerks, insbesondere zur Detektion von Teilentladungen, sowie ein Messknoten zur Verwendung in einem derartigen System bzw. ein entsprechendes Verfahren.

Teilentladungen, häufig mit TE abgekürzt, sind nach IEC 60270 definiert als lokale dielektrische Durchschläge in einem kleinen Bereich eines elektrischen Isolators unter hoher Feldbeanspruchung. Der Isolator ist dabei meist ein Feststoff oder eine Flüssigkeit, kann aber auch durch ein Gas gebildet sein. Die durch TE hervorgerufene leitende Verbindung besteht nur für sehr kurze Zeit, üblicherweise unter 1 µs. Die während einer Teilentladung abgeleitete Ladung liegt üblicherweise im Pico-Coulomb-Bereich, beispielsweise zwischen 5 pC und wenigen 100 pC bei 24 kV. Dennoch führen Teilentladungen zu Energieverlusten und bei entsprechender Intensität der TE zu einer zunehmenden Schädigung der betroffenen Isolatoren. Da Betriebsmittel in Energieversorgungsnetzwerken, insbesondere ab Mittelspannungsebene (d.h. bei Wechselspannungen mit Effektivwerten zwischen 1 kV und 52 kV), derart ausgelegt sind, dass TE praktisch nicht oder nur mit geringem Ausmaß auftreten (beispielsweise bei unter 5 pC bei 24 kV), deutet das Vorhandensein von TE (beispielsweise über 90 pC bei 24 kV) auf eine Schädigung eines Isolators (beispielsweise infolge von Alterung), eine fehlerhafte Installation eines Betriebsmittels oder eine Störung der Feldverteilung innerhalb eines Betriebsmittels (beispielsweise durch Beschädigung eines Leiters oder Einlagerung von Wasser in einer Kabelmuffe) hin. Häufig ist dies ein Indiz für einen baldigen vollständigen Durchschlag des elektrischen Isolators oder einen anderweitigen Ausfall eines Betriebsmittels. Daher sollten an Betriebsmitteln, beispielsweise Mittelspannungserdkabeln, zumindest gelegentlich TE-Messungen durchgeführt werden.

Derzeit werden TE-Messungen an Hoch- und Mittelspannungsanlagen mit speziellen Messwagen der Energieversorger oder akkreditierten Prüflabore bzw. Dienstleister, wie beispielsweise die KEMA, durchgeführt. Messwagen sind meist Lastkraftwagen, in die entsprechendes Messequipment eingebaut ist. Hierzu kommen spezielle Messgeräte (z.B. Omicron MPD500 mit TE-Ortung) zum Einsatz, die über einen Koppelkondensator inklusive Messimpedanz (z.B. Omicron MCC124) an die zu vermessende Anlage angekoppelt werden und die TE-Messungen durchführen. Derartige Geräte sind teuer und schlagen mit etwa 20.000 € zu buche. Zu dem eigentlichen Messequipment kommt noch ein Spannungsgenerator hinzu, der das zu untersuchende Mittelspannungskabel getrennt vom Netz versorgt, um äußere EMV (Elektro-Magnetische Verträglichkeit)-Einflüsse zu minimieren und die Messqualität zu erhöhen. Durch das teure technische Equipment und den Bedarf an speziell geschultem Personal sind diese Messwagen und deren Betrieb sehr teuer und selten. In Deutschland sind derzeit - Schätzungen zufolge - lediglich 30 dieser Messwagen im Einsatz, von denen jeder mehrere 100k € kostet. Die MVV Energie AG besitzt als sechstgrößter Energieversorger Deutschlands beispielsweise nur einen Messwagen, um TE-Messungen an Kabeln durchzuführen. Aus Kostengründen werden die Messwagen bei Bedarf auch zwischen Energieversorgern gegenseitig verliehen.

Die zu messenden Leitungen müssen für jede Messung freigeschaltet werden, was zur Abschaltung der angeschlossenen Stromkunden führen kann und daher ebenfalls aufwändig ist. Insbesondere bei Industriekunden, die meist auf Ausfallsicherheit bedacht sind, ist dies sehr teuer. Insgesamt werden daher derzeit während des regulären Netzbetriebs keine TE-Messungen durchgeführt. Vielmehr sind TE-Messungen auf ohnehin stattfindende Wartungsarbeiten oder gar den Ausfall einer Strecke des Energieversorgungsnetzwerks beschränkt.

Bei den bekannten TE-Messverfahren können Messungen nur punktuell und zeitversetzt und nicht flächendeckend oder gar durchgehend durchgeführt werden, da weder genügend Geräte zur Verfügung stehen noch eine Echtzeitsynchronisierung aller Geräte gewährleistet ist. Rückschlüsse der Teilentladung in Bezug auf temporäre Ereignisse oder ein besseres Verständnis der zeitlichen Degration der Netzinfrastruktur (d.h. der zeitliche Verlauf einer Zerstörung infolge von Alterungsvorgängen) sind somit ausgeschlossen. Jahreszeitliche, tägliche und sonstige sich wiederholende Muster können nicht aufgedeckt und analysiert werden.

Die Planbarkeit von Service an Kabeln ist stark erschwert, da der Netzbetreiber wegen der hohen Kosten seine Infrastruktur nicht flächendeckend vermessen kann. Derzeit wird in der Infrastruktur von Mittelspannungsnetzen meist nur auf Ereignisse (z.B. bei Kabelbruch) reagiert und erst nach Ausfall einer Komponente untersucht. Kabel bzw. Kabelteile rechtzeitig vor einem Ausfall geplant zu ersetzen, würde Kosten einsparen, da man dann systematisch Segmente analysieren könnte und durch einen Ausfall nicht unter erheblichem Zeitdruck eine Lösung herbeigeführt werden müsste, die primär auf die Wiederherstellung der Energieversorgung ausgerichtet sein wird.

Zur Überwachung von Kabeln bzw. zum Aufdecken von Problemen zum Einleiten geeigneter Gegenmaßnahmen sind Überwachungssysteme bekannt, wie beispielsweise das durch die Firma NKT Cables GmbH unter der Marke Valcap vertriebene System. Es ermöglicht durch Einsatz von Glasfasern in Energieversorgungskabeln die Überwachung der Temperatur und Leistungsübertragung sowie temporäre externe Ereignisse wie Grabungen, Bohrung und Stoß. Damit kann bei Beschädigungen am Kabelsystem auch der Verursacher ausfindig gemacht werden. Dieses System ist jedoch auf neue Kabel begrenzt; bestehende Strecken können nicht überwacht werden. Damit sind die Installationskosten sehr hoch, so dass die Investitionskosten für einen flächendeckenden Ersatz von Kabeln in einem nicht ausgewogenen Verhältnis zu dem Nutzen stehen. Ferner ist das System darauf beschränkt, Degration verursachende Faktoren (Überlast, Übertemperatur) aufzudecken. Die tatsächliche Degration, also das tatsächliche Ausmaß der Zerstörung eines Kabels, kann damit jedoch nicht bestimmt werden.

Der vorliegenden Erfindung liegt daher die Aufgabe zugrunde, einen Messknoten, ein System und ein Verfahren der eingangs genannten Art derart auszugestalten und weiterzubilden, dass eine möglichst umfassende Überwachung des Zustands eines Stromversorgungsnetzwerks oder eines Teilbereichs davon im laufenden Betrieb des Netzwerks und bei gleichzeitig möglichst niedrigen Kosten gewährleistet ist.

Erfindungsgemäß wird die voranstehende Aufgabe durch die Merkmale des Anspruchs 1 gelöst. Danach umfasst der in Rede stehende Messknoten:
ein Koppelnetzwerk, das an das Energieversorgungsnetzwerk ankoppelbar ist und das zum Auskoppeln eines Störsignals aus dem Energieversorgungsnetzwerk ausgebildet ist,
eine Filterschaltung, die mit dem Koppelnetzwerk verbunden ist und die durch Bandpassfilterung aus dem Störsignal ein Messsignal erzeugt, wobei der Bandpass derart dimensioniert ist, dass das Messsignal zumindest eine für den Zustand des Energieversorgungsnetzwerk repräsentative Komponente enthält, und
eine Auswerteeinheit, die zur Analyse des Messsignals über einen Auswertezeitraum hinweg ausgebildet ist, wobei bei der Analyse der zeitliche Verlauf von zumindest Teilen des Messsignals relativ zu der Netzspannung ausgewertet wird und wobei die Analyse des Messsignals eine Bewertungsgröße für den Zustand des Teilbereichs des Energieversorgungsnetzwerks liefert.

Hinsichtlich eines Systems ist die voranstehende Aufgabe durch die Merkmale des Anspruchs 9 gelöst. Danach umfasst das in Rede stehende System:
mehrere Messknoten, vorzugsweise Messknoten nach einem der Ansprüche 1 bis 8, wobei die Messknoten über ein geografisches Gebiet verteilt und jeweils zur Überwachung eines Teilbereichs des Energieversorgungsnetzwerks mittels eines Koppelnetzwerks mit dem Energieversorgungsnetzwerk verbunden sind und wobei jeder Messknoten aus Störsignalen, die über das Koppelnetzwerk aus den Energieversorgungsnetzwerk ausgekoppelt sind, ein Messsignal und/oder eine Bewertungsgröße für den Zustand des Teilbereichs des Energieversorgungsnetzwerks bestimmt,
ein Weitbereichsnetzwerk zur Kommunikation mit den Messknoten,
ein Server, der über das Weitbereichsnetzwerk kommunizierend mit den Messknoten verbunden ist, wobei der Server dazu ausgebildet ist, digitalisierte Messsignale und/oder Bewertungsgrößen von den Messknoten zu empfangen und abzuspeichern.

Hinsichtlich eines Verfahrens ist die voranstehende Aufgabe durch die Merkmale des Anspruchs 12 gelöst. Danach umfasst das in Rede stehende Verfahren die Schritte:
Auskoppeln eines Störsignals aus dem Energieversorgungsnetzwerk mittels eines Koppelnetzwerks bei einem von mehreren über ein geografisches Gebiet verteilten Messknoten - erster Messknoten,
Erzeugen eines Messsignals aus dem Störsignal bei dem ersten Messknoten durch Bandpassfilterung, wobei das Messsignal derart gebildet wird, dass das Messsignal zumindest eine für den Zustand des Energieversorgungsnetzwerks repräsentative Komponente enthält,
Analysieren des Messsignals über einen Auswertezeitraum hinweg, wobei der zeitliche Verlauf von zumindest Teilen des Messsignals relativ zu der Netzspannung ausgewertet wird,
Erzeugen einer Bewertungsgröße für den Zustand eines mit dem ersten Messknoten verbundenen Teilbereichs des Energieversorgungsnetzwerks basierend auf dem Ergebnis der Analyse und
Speichern der Messsignale und/oder Bewertungsgrößen bei einem Server, der über ein Weitbereichsnetzwerk mit den Messknoten verbunden ist.

In erfindungsgemäßer Weise ist zunächst erkannt worden, dass eine Überwachung des Zustands eines Energieversorgungsnetzwerks auch ohne die Verwendung von Messwagen oder speziell ausgestalteter Kabelstrecken möglich ist. Stattdessen lässt sich ein kostengünstiger Messknoten aufbauen, der eine kontinuierliche Überwachung des Zustands eines Energieversorgungsnetzwerks ermöglicht. Damit lässt sich wiederum ein relativ kostengünstiges System zur Überwachung des Zustands eines Energieversorgungsnetzwerks aufbauen. Entsprechend kommt der Messknoten im laufenden Betrieb des Energieversorgungsnetzwerks zum Einsatz, so dass an dem Energieversorgungsnetzwerk eine Netzspannung anliegt. Unter Netzspannung wird die Spannung verstanden, die zur Übertragung der Energie in dem Energieversorgungsnetzwerk verwendet wird, beispielsweise 10 kV oder 24kV um lediglich zwei gebräuchliche Mittelspannungsniveaus zu nennen. Erfindungsgemäß ist der Messknoten dazu ausgebildet, aus dem Energieversorgungsnetzwerk ein Messsignal zu gewinnen, das Rückschlüsse auf den Zustand des Energieversorgungsnetzwerks bzw. eines Teilbereichs in der Nähe des Messknotens ermöglicht. Der erfindungsgemäße Messknoten umfasst hierzu ein Koppelnetzwerk, eine Filterschaltung und eine Auswerteeinheit.

Das Koppelnetzwerk ist zum Ankoppeln an eine der Phasen des Energieversorgungsnetzwerks ausgebildet. Das Koppelnetzwerk koppelt Störsignale aus dem Energieversorgungsnetzwerk aus, während die Netzspannung blockiert wird. Als Störsignale werden alle Anteile der an einem Energieversorgungsnetzwerk anliegenden Spannung angesehen, die nicht von der eigentlichen Netzspannung mit üblicherweise 50 Hz oder 60 Hz herrühren. Die ausgekoppelten Störsignale umfassen verschiedenste Signale, die beispielsweise von verschiedenen mit dem Energieversorgungsnetzwerk verbundenen Verbrauchern und Erzeugern, den einzelnen, das Energieversorgungsnetzwerk aufspannenden Betriebsmitteln, in die Leitungen des Energieversorgungsnetzwerks einstreute Funksignalen oder Kommunikationssignalen, wie beispielsweise Powerline-Communication-Signale - PLC-Signale - herrühren. Die Störsignale können vom einstelligen Kilohertzbereich bis hinein in den zwei- oder gar dreistelligen Megahertzbereich reichen. Abhängig davon, welche Informationen über den Zustand des Energieversorgungsnetzwerks bzw. eines Teilbereichs des Energieversorgungsnetzwerks gewonnen werden sollen, kann das Koppelnetzwerk zur Auskopplung eines entsprechend zu erwartenden Frequenzbereichs ausgebildet sein.

Die Filterschaltung ist mit dem Koppelnetzwerk verbunden und empfängt die durch das Koppelnetzwerk aus dem Energieversorgungsnetzwerk ausgekoppelten Störsignale. Die Filterschaltung erzeugt aus dem Störsignal ein Messsignal, indem ein Teilbereich der Frequenz des Störsignals herausgefiltert wird. Es ist erkannt worden, dass viele Störsignale, die auf spezielle Beeinträchtigungen des Energieversorgungsnetzwerks zurückzuführen sind, einen charakteristischen Zeitverlauf, ein charakteristisches Spektrum und/oder eine charakteristische Frequenz aufweisen. Entsprechend filtert die Filterschaltung mit einer Bandpass-Charakteristik Teile des Frequenzbereichs der Störsignale heraus, wobei die verbleibenden Anteile Komponenten enthalten, die für den Zustand des Energieversorgungsnetzwerks repräsentativ sind.

Das durch die Filterschaltung gewonnene Messsignal wird der Auswerteeinheit zugeführt. Die Auswerteeinheit analysiert das Messsignal über einen Auswertezeitraum hinweg. Dabei wird der zeitliche Verlauf des Messsignals oder Teile des zeitlichen Verlaufs ausgewertet, beispielsweise hinsichtlich besonderer Peaks, dem Überschreiten von Schwellenwerten oder dem Wechsel der Polarität des Messsignals. Für einige Messsignale, insbesondere bei zu messenden Teilentladungen, ist der zeitliche Bezug des Messsignals zu der Netzspannung des Energieversorgungsnetzwerks von Bedeutung. Teilentladungen führen zu netzsynchronen Störungen, die konstant bei jeder Periode der Netzspannung an im Wesentlichen gleichbleibender Position in Bezug auf die Periode der Netzspannung auftreten. Aus der Position des Messsignals relativ zu der Periode der Netzspannung lassen sich sogar Rückschlüsse über die Art der Teilentladung ziehen. Daher wird bei der Auswertung des zeitlichen Verlaufs des Messsignals oder zumindest Teilen des Messsignals dessen zeitlicher Bezug zu der Netzspannung ausgewertet. Hierzu wird der Auswerteeinheit zusätzlich zu dem Messsignal ein Signal zugeführt, das zumindest einzelne Informationen zu der Netzspannung enthält, insbesondere Informationen über deren zeitlichen Verlauf. Man könnte dieses Signal also als "Netzsignal" bezeichnen. Das Netzsignal kann ein in seiner Amplitude reduziertes Abbild der Netzspannung sein. Andererseits wäre es auch möglich, das Netzsignal derart zu reduzieren, dass es lediglich, beispielsweise bei einem Nulldurchgang der Netzspannung, einen kurzen Puls aufweist, wobei die Polarität des Pulses Informationen über die Richtung der Spannungsänderung enthält. Einem Fachmann wird einleuchten, wie universell dieses Netzsignal aufgebaut sein kann.

Aus der Analyse des Messsignals bildet die Auswerteeinheit eine Bewertungsgröße, die für den Zustand des Teilbereichs des Energienetzwerks repräsentativ ist. Wie die Bewertungsgröße aussieht, hängt von der zu bewertenden physikalischen Größe ab. Wenn beispielsweise die Intensität von Teilentladungen in dem mit dem Messknoten verbundenen Teilbereich des Energieversorgungsnetzwerks ermittelt werden soll, kann die Bewertungsgröße eine Zahl sein, die die während einer Teilentladung abgeleitete Ladung angibt. Die Korrespondenz zwischen Größe des Messsignals und abgeleiteter Ladung kann durch Kalibrierungsmessungen vor Inbetriebnahme des Messknotens bestimmt werden. Andererseits kann die Bewertungsgröße auch auf einfache Aussagen reduziert werden, wie beispielsweise "praktisch keine TE" oder "erhebliche TE".

Da der Messknoten dazu ausgelegt ist, dauerhaft an das Energieversorgungsnetzwerk angekoppelt zu sein, müssen die Komponenten nicht für jede Messung erneut an dem Energieversorgungsnetzwerk installieren werden. Es ist - außer für eine initiale Installation der Messknoten - keine Freischaltung einer Teilstrecke des Energieversorgungsnetzwerks notwendig, um eine Messung durchführen zu können. Da insbesondere Mittelspannungsnetze derzeit ohnehin verstärkt für eine Powerline-Kommunikation erschlossen werden, kann der erfindungsgemäße Messknoten ohne großen Zusatzaufwand mit installiert werden bzw. die Stellen für PLC-Knoten lassen sich für den erfindungsgemäßen Messknoten vorbereiten. Durch die automatische Analyse des Messsignals ist ferner die Notwendigkeit einer Analyse durch Fachpersonal deutlich reduziert. Das Fachpersonal kann sich darauf beschränken, bei Erkennen eines potentiellen Problems die gewonnenen Ergebnisse zu überprüfen oder die Qualität der Analyse gelegentlich zu überprüfen. All diese Aspekte sorgen dafür, dass ein Messknoten kostengünstig betrieben werden kann und dass gleichzeitig dauerhafte Messungen an dem Energieversorgungsnetzwerk durchgeführt werden können. Hinzu kommt, dass ein Messknoten mit Standardkomponenten aufgebaut werden kann, wodurch ein kostengünstiger Messknoten entsteht. Dies ermöglicht ein kostengünstiges System zur flächendeckenden Überwachung eines Energieversorgungsnetzwerks. Die zeitliche Degration von Komponenten wird überwachbar und es kann rechtzeitig vor Auswahl einer Komponente reagiert werden.

Die Filterschaltung umfasst vorzugsweise einen Hochpassfilter, einen Verstärker, einen Analog/Digital-Wandler (ADC) und einen digitalen Signalprozessor (DSP). Der Hochpassfilter unterdrückt niederfrequente Anteile, die durch das Koppelnetzwerk durchgelassen wurden. Gleichzeitig kann er dazu genutzt werden, das Störsignal für eine weitere Bearbeitung vorzubereiten, beispielsweise zur Vorbereitung einer späteren Überabtastung. Damit kann der Hochpassfilter eine weitere Vorfilterung des Störsignals vornehmen. Der Verstärker weist vorzugsweise eine automatische Verstärkungsregelung auf, wie sie aus dem Stand der Technik bekannt sind. Bevor das derart hochpassgefilterte und verstärkte Störsignal dem ADC zugeführt wird, kann ein Downsampling erfolgen, d.h. das Störsignal wird heruntergetaktet. Vor dem Downsampling kann wiederum eine Überabtastung des gefilterten und verstärkten Störsignals mit einer hohen Abtastfrequenz erfolgen. Das resultierende zeitdiskrete Signal würde dann mit einem zeitdiskreten Filter bandpassgefiltert. Danach wird die Abtastfrequenz des resultierenden zeitdiskreten Signals mit dem Downsampling wieder reduziert, wodurch die Folgen der Überabtastung beseitigt werden. Durch Überabtastung und anschließendem Downsampling kann die Flankensteilheit der Filter deutlich geringer gewählt werden.

Das derart hochpassgefilterte und verstärkte, gegebenenfalls mit Downsampling in seiner Frequenz reduzierte Störsignal würde dann dem ADC zugeführt und dort in diskrete Werte gewandelt. Damit liegt am Ausgang des ADC ein zeit- und wertdiskretes Signal (also ein digitalisiertes Signal) vor. Das digitalisierte Zeitsignal kann danach in dem DSP weiterverarbeitet werden.

Vorzugsweise findet in dem DSP eine Fourier-Transformation-basierte Weiterverarbeitung des digitalisierten Störsignals statt. Der DSP kann hierzu als ADSP (Advanced DSP) ausgebildet und damit bereits auf die entsprechende Anwendung optimiert sein. Das digitalisierte Störsignal kann zunächst eine Fourier-Transformation unterzogen werden, wodurch die spektralen Anteile des digitalisierten Störsignals extrahiert werden. Aus den spektralen Anteilen kann mittels einer Auswahleinrichtung ein bestimmter Bereich oder mehrere Bereiche ausgewählt werden, der dann mit einer inversen Fourier-Transformation wieder in ein Zeitsignal zurücktransformiert wird. Im Bereich der digitalen Signalverarbeitung hat sich als besonders vorteilhaft erwiesen, die Fourier-Transformation als DFFT (Discrete Fast Fourier Transform) auszugestalten. Entsprechend ist die inverse Fourier-Transformation als IDFFT (Inversed DFFT) ausgebildet. Da die spektralen Anteile bei einer diskreten Fourier-Transformation als Koeffizienten für diskrete Frequenzanteile vorliegen, würde die Auswahleinrichtung in diesem Fall einen oder mehrere Koeffizienten des Fourier-transformierten Eingangssignals auswählen. Das in das Zeitsignal zurücktransformierte Signal, das als Messsignal schließlich ausgegeben wird, ist ein stark bandpassgefilterter Teil der eingegebenen Störsignale und liegt bei dieser Ausgestaltung in digitaler Form vor. Auf diese Weise entsteht ein Messsignal, das geeignet auswertbar ist. Durch Veränderung der mit der Auswahleinrichtung ausgewählten spektralen Anteile kann zudem sehr einfach der bandpassgefilterte Anteil des Störsignals flexibel angepasst und zur Laufzeit des Systems verändert werden.

In einigen Anwendungsfällen kann es notwendig sein, nicht lediglich nur aus einer Phase des Energieversorgungsnetzwerks Messsignale zu extrahieren. Für diesen Zweck kann der Messknoten dazu ausgebildet sein, an mehrere Phasen des Energieversorgungsnetzwerks angekoppelt zu werden. Hierzu ist es sinnvoll, wenn für jede Phase, an die der Messknoten angekoppelt werden soll, ein separates Koppelnetzwerk und eine separate Filterschaltung vorhanden ist. Bei der Filterschaltung ist es denkbar, dass einzelne Komponenten gemeinsam verwendet werden. Wenn beispielsweise die Filterschaltung einen DSP aufweist, der eine Fourier-Transformation von Eingangssignalen durchführt, und wenn der Messknoten zur Ankopplung an alle drei Phasen eines Mittelspannungsnetzwerks angekoppelt werden soll, kann der DSP - bei ausreichender Rechenkapazität - zur Fourier-Transformation der vorgefilterten Störsignale aus allen drei Phasen verwendet werden.

In einer einfachen Ausgestaltung kann das Koppelnetzwerk einen Koppelkondensator und/oder einen Transformator umfassen. Es wäre denkbar, dass ein Koppelkondensator mit einem Anschluss mit einer Phase des Energieversorgungsnetzwerks verbunden ist, während der zweite Anschluss des Koppelkondensators mit einem Anschluss der Primärwicklung des Transformators verbunden ist. Der zweite Anschluss der Primärwicklung könnte auf Erdpotential gelegt sein. Dieses Koppelnetzwerk kann neben dem Auskoppeln von Störsignalen auch dazu verwendet werden, Powerline-Communication (PLC)-Signale, insbesondere Breitband-Powerline-Signalen (BPL-Signalen), auf die Phase des Energieversorgungsnetzwerks zu koppeln, falls der Messknoten zusätzlich ein PLC- bzw. BPL-Endgerät umfasst. Nachteilig an dieser Doppelverwendung ist, dass das Koppelnetzwerk in einer Art Kompromissdimensionierung für Kommunikations- und Messanwendung ausgestaltet sein muss.

In einer anderen Ausgestaltung ist das Koppelnetzwerk sowohl für das Auskoppeln von Störsignalen aus dem Energieversorgungsnetzwerk als auch für eine Übertragung von PLC-Signalen in und aus dem Energieversorgungsnetzwerk optimiert. Dazu kann das Koppelnetzwerk einen Koppelkondensator, eine erste Koppelschaltung und eine zweite Koppelschaltung umfassen. Der Koppelkondensator wäre dann mit einem Anschluss an einer Phase des Energieversorgungsnetzwerks angekoppelt, während der zweite Anschluss mit jeweils einem Anschluss der ersten und der zweiten Koppelschaltung verbunden ist. Dadurch sind die erste und die zweite Koppelschaltung parallel geschaltet. Dabei ist die erste Koppelschaltung vorzugsweise zum Weiterleiten von PLC-Signalen zwischen dem Energieversorgungsnetzwerk und einem PLC-Endgerät ausgestaltet. Die zweite Koppelschaltung kann dazu optimiert sein, Störsignale zum Erzeugen eines Messsignals aus dem Energieversorgungsnetzwerk auszukoppeln. Die erste und die zweite Koppelschaltung können dabei jeweils aktive und passive Bauelemente, beispielsweise Kondensatoren, Spulen, Transformatoren, Verstärker oder dergleichen umfassen. Durch die Auftrennung des Koppelnetzwerks in zwei Koppelschaltungen und die Optimierung der beiden Koppelschaltungen auf unterschiedliche Verwendungszwecke kann das Koppelnetzwerk sowohl für Mess- als auch für Kommunikationszwecke optimal arbeiten und auf den jeweiligen Verwendungszweck optimal eingestellt werden. Durch eine derartige Ausgestaltung des Koppelnetzwerks kann der Messknoten noch besser seine Aufgabe erfüllen.

Zum Bereitstellen einer Kommunikation mit dem Messknoten weist der Messknoten vorzugsweise ein Kommunikationsgerät auf, mit dem eine Kommunikation über eine Weitbereichsschnittstelle ermöglicht ist. Diese Weitbereichsschnittstelle kann auf verschiedene Weisen implementiert sein. Denkbar wäre beispielsweise die Verwendung von DSL-Varianten, wie beispielsweise ADSL (Asynchronous Digital Subscriber Line) oder VDSL (Very Highspeed Digital Subscriber Line). In einer bevorzugten Ausgestaltung wird die Weitbereichsschnittstelle jedoch durch BPL bereitgestellt, so dass das Kommunikationsgerät ein BPL-Modem ist. Durch die Verwendung von BPL kann eine Kommunikationsfähigkeit mit einem Messknoten erzielt werden, ohne dedizierte Kommunikationsleitungen zu dem Messknoten verlegen zu müssen. Da BPL auf verschiedenen Spannungsniveaus genutzt werden kann, unter anderem auch auf Mittelspannungsebene, sind entsprechende Kommunikationstechniken am Markt verfügbar. Auf diese Weise kann die Installation eines Messknotens mit gleichzeitiger Kommunikationsfähigkeit deutlich vereinfacht werden, wodurch sich die Kosten der Installation und des Betriebs des Messknotens weiter reduzieren.

Zum Ermöglichen einer Anpassbarkeit des Messknotens an verschiedene Messszenarien kann die Filterschaltung anpassbar ausgebildet sein. Auf diese Weise kann beispielsweise die Bandpass-Charakteristik der Filterschaltung geeignet verschoben werden, falls ein ursprünglich für die Extraktion des Messsignals verwendetes Frequenzband durch starke anderweitige Störungen nicht mehr nutzbar ist. Bei Anpassung der Bandpassfilterung kann eine Anpassung erfolgen, indem in der Filterschaltung die Mittelfrequenz und/oder die Bandbreite des Bandpassfilters verändert werden. Bei Implementierung des Bandpassfilters in einem DSP mit Auswahl von einzelnen Koeffizienten eines DFFT-transformierten Signals kann eine Anpassung besonders einfach erfolgen, indem für die Rücktransformierung andere Koeffizienten verwendet werden. Denkbar wäre aber auch, die Filterschaltung durch anpassbare Elemente, wie beispielsweise steuerbare Widerstände oder steuerbare Kondensatoren anpassbar auszugestalten.

Vorzugsweise wird ein Messsignal in dem Messknoten digitalisiert. Die Digitalisierung kann - wie zuvor mit Bezug auf eine bevorzugte Ausführungsform ausgeführt - bereits während der Bandpassfilterung erfolgen. Denkbar wäre aber auch, das die Filterschaltung verlassende Messsignal einem Analog/Digital-Wandler zuzuführen und damit erst nach der Bandpassfilterung eine Digitalisierung durchzuführen. Diese digitalisierten Messwerte, die in ihrer zeitlichen Abfolge das Messsignal repräsentieren, werden vorzugsweise über eine Weitbereichsschnittstelle übertragen. Um die Verbindung optimal zu nutzen, kann der Messknoten einen Speicher aufweisen, der digitalisierte Messwerte eines Messsignals und/oder bereits in dem Messknoten berechnete Bewertungsgrößen zwischenspeichert. Hierbei wäre auch denkbar, einzelne Messwerte und/oder Bewertungsgrößen zu aggregieren, so dass lediglich ein einzelner aggregierter Wert, der für mehrere Messwerte oder für mehrere Bewertungsgrößen repräsentativ ist, übertragen werden muss. Ob mit oder ohne Aggregieren erlaubt eine Zwischenspeicherung, dass auch bei kurzzeitigem Ausfall oder einer Blockade der Weitbereichsschnittstelle weiterhin Messwerte versendet werden können.

Vorzugsweise umfasst der Messknoten zusätzlich eine Uhr, die die aktuelle Uhrzeit am Ort des Messknotens angibt. Die Uhr kann dabei synchronisierbar ausgestaltet sein, d.h. von einem Zeitnormal wird eine Referenzzeit an die Uhr gesendet und die Uhr stellt sich auf die aktuell empfangene Referenzzeit ein. Dies kann beispielsweise durch ein funkbasiertes System, wie dem in Deutschland weit verbreiteten DCF77, implementiert sein. Entsprechende Funkuhren sind zu relativ günstigem Preis verfügbar. Denkbar wäre jedoch auch eine Synchronisation mit einem Zeitserver im Internet, wenn der Messknoten über eine Weitbereichsschnittstelle verfügt. Immer dann wenn ein Messwert erzeugt oder eine Bewertungsgröße berechnet wird, kann die aktuelle Uhrzeit der Uhr ausgelesen werden und der ausgelesene Zeitpunkt als Zeitstempel für das Messsignal oder die Bewertungsgröße zusammen mit dem Messsignal oder der Bewertungsgröße abgespeichert werden. Auf diese Weise ist es möglich, historische Werte der Messsignale oder der Bewertungsgrößen zu bestimmen und gleichzeitig einen Bezug zu dem Zeitpunkt der Messung zu behalten.

Der Messknoten kann zusätzlich eine Steuereinheit aufweisen. Die Steuereinheit kann zum Empfangen von Steuerparametern für den Messknoten ausgebildet sein, wobei die Steuerparameter vorzugsweise über eine Weitbereichsschnittstelle an den Messknoten übermittelt werden. Auf diese Weise kann über die Weitbereichsschnittstelle von einer Leitwarte aus Steuerparameter an den Messknoten versendet, bei der Steuereinheit empfangen und schließlich in geeigneter Form an die Filterschaltung und/oder die Auswerteeinheit zur Durchführung entsprechender Anpassungen geleitet werden. Gleichzeitig wäre es möglich, dass die Steuereinheit Aufgaben zur Aufbereitung digitalisierter Messsignale übernimmt. Dies kann beispielsweise dadurch geschehen, dass das bereits angesprochene Aggregieren mehrerer Messwerte des Messsignals/Bewertungsgrößen oder die Zwischenspeicherung von Messwerten(Bewertungsgrößen bei der Steuereinheit erfolgt. Die Steuereinheit kann dabei als Mikroprozessor-gestützte Einheit implementiert sein. Es ist auch denkbar, dass die Steuereinheit und die Auswerteeinheit in einer gemeinsamen Rechnereinheit implementiert sind, indem beispielsweise die Programme für die Steuereinheit und die Auswerteeinheit gemeinsam in einem DSP abgearbeitet werden.

Ein erfindungsgemäßes System zur Überwachung des Zustands eines Energieversorgungsnetzwerks, das vorzugsweise zur Detektion von Teilentladungen ausgestaltet ist, umfasst mehrere Messknoten (insbesondere eine Vielzahl von Messknoten), ein Weitbereichsnetzwerk und einen Server, der über das Weitbereichsnetzwerk kommunizierend mit den Messknoten verbunden ist. Die Messknoten sind über ein geografisches Gebiet verteilt und überwachen jeweils einen mit dem Messknoten unmittelbar verbundenen Teilbereich des Energieversorgungsnetzwerks. Jeder Messknoten ist über ein Koppelnetzwerk mit dem Energieversorgungsnetzwerk verbunden, koppelt über das Koppelnetzwerk Störsignale aus dem Energieversorgungsnetzwerk aus und erzeugt aus den Störsignalen ein Messsignal und/oder eine Bewertungsgröße für den Zustand des verbundenen Teilbereichs des Energieversorgungsnetzwerks. Ein Messknoten des erfindungsgemäßen Systems kann beispielsweise in einer Trafostation, einer Schaltstation oder einem anderen für den Betrieb des Energieversorgungsnetzwerks relevanten Punkt angeordnet sein. Prinzipiell wäre aber auch denkbar, einen Messknoten an einem Freileitungsmasten anzubringen und mit einer oder mehreren Phasen des Energieversorgungsnetzwerks zu verbinden. Der überwachbare Teilbereich kann jede der von dem Installationsort des Messknoten aus abgehenden Teilstrecken des Energieversorgungsnetzwerks umfassen. Gleichzeitig kann aber auch lediglich eine einzelne von dem Installationsort abgehende Teilstrecke des Energieversorgungsnetzwerks überwacht werden, wenn beispielsweise Störsignale aus den anderen an dem Installationsort endenden Leitungen nicht in die überwachte Leitung überkoppeln.

Der Server ist dazu ausgebildet, digitalisierte Messsignale (bzw. digitalisierte Messwerte, die die Messsignale in ihrer zeitlichen Reihenfolge zusammensetzen und die hier weitgehend synonym zu dem digitalisierten Messsignal verwendet werden) und/ oder Bewertungsgrößen von verbundenen Messknoten zu empfangen und abzuspeichern.

Vorzugsweise weist der Server einen Massenspeicher auf oder ist in geeigneter Weise, beispielsweise über eine Netzwerkverbindung, mit einem Massenspeicher verbunden. Der Massenspeicher kann auf die unterschiedlichsten Arten ausgebildet sein, wobei eine nicht-flüchtige Speicherung der empfangenen Daten Voraussetzung sein sollte. Eine derzeit am weitesten verbreitete Ausgestaltung eines derartigen Massenspeichers besteht in einer Festplatte oder einem RAID (Redundant Array of Independent Disks). Der Server speichert die von einem Messknoten über das Weitbereichsnetzwerk empfangenen Messsignale und/oder Bewertungsgrößen auf dem Massenspeicher ab. Dabei kann vor der Speicherung auch eine Aufbereitung der empfangenen Daten erfolgen, beispielsweise in Form einer Normierung, Ändern der Datenstruktur oder dergleichen.

Zusätzlich kann der Server dazu ausgebildet sein, über die in dem Massenspeicher abgespeicherten Messsignale und/oder Bewertungsgrößen eine Langzeitanalyse durchzuführen. Hierbei können auch Daten von mehreren Messknoten kombiniert werden, beispielsweise durch Korrelation der Daten. Über die Langzeitanalyse lässt sich beispielsweise feststellen, ob sich durch einen Messknoten detektierte Teilentladungen im Laufe der Zeit verändern, insbesondere in ihrer Intensität zunehmen. Auf diese Weise kann festgestellt werden, ob Maßnahmen zur Behebung aufkommender Probleme eingeleitet werden müssen. Auch sind gewisse Rückschlüsse über die Ursache einer Störung möglich. Wenn beispielsweise vorhandene Teilentladungen sprungartig ansteigen und in dieser Intensität erhalten bleiben, deutet dies auf eine erhebliche mechanische Beanspruchung eines Kabels, beispielsweise bei Baggerarbeiten, hin. Wenn Teilentladungen immer dann verstärkt auftreten, wenn länger anhaltender Regen gefallen ist, deutet dies auf ein Problem mit Feuchtigkeit hin, beispielsweise in Kabelmuffen. Über die Geschwindigkeit der Veränderungen kann zudem eine Abschätzung vorgenommen werden, wie schnell eine Degration voranschreitet. Wenn Teilentladungen beispielsweise an einem Erdkabel innerhalb einer Woche von einem noch relativ geringen Teilentladungswert kontinuierlich auf einen vergleichsweise hohen Teilentladungswert anwächst, kann dies als Hinweis auf eine Überlastung des Kabels oder eine Zerstörung einer Ummantelung des Kabels, die zu einer verstärken Korrosion führt, angesehen werden. Auf diese Weise kann aus einer Langzeitanalyse Informationen über das Energieversorgungsnetzwerk gewonnen werden, die ein frühzeitiges Reagieren auf aufkommende Probleme erlauben.

Es ist auch möglich, dass in dem Server eine Auswerteeinheit ausgebildet ist, in der einzelne Funktionen der Auswerteeinheiten mehrerer Messknoten des Systems zusammengefasst sind. Die Auswerteeinheiten der Messknoten müssten dann diese an den Server übertragenen Auswerteschritte nicht mehr ausführen. Denkbar wäre beispielsweise, dass ein Messknoten lediglich zur Erzeugung eines digitalisierten Messsignals verwendet wird, die digitalisierten Messsignale an den Server überträgt und die Erzeugung von Bewertungsgrößen durch die Auswerteeinheit des Servers übernommen wird. Dadurch kann die an einem Messknoten bereitgestellte Rechenleistung relativ gering gehalten werden, wodurch die Kosten eines Messknotens weiter reduziert werden können. An einem Server kann mit relativ geringen Kostenaufwand ausreichende Rechenleistung zur Verfügung gestellt werden, der für die Auswertung genutzt werden kann. Zwar dürfte dadurch eine größere Datenmenge zwischen Messknoten und Server zu übertragen sein, als dies bei ausschließlichem Übertragen von bereits berechneten Bewertungsgrößen an den Server notwendig wäre. Allerdings stellen die meist recht geringen Datenraten keine allzu große Herausforderung heutiger Weitbereichsnetzwerke dar.

In einer bevorzugten Ausgestaltung werden in dem erfindungsgemäßen System die zuvor beschriebenen erfindungsgemäßen Messknoten verwendet. Dabei können ergänzend aber auch weitere Messknoten integriert sein, die kommunizierend mit dem Server verbunden werden. Denkbar wären Messknoten, die beispielsweise die an einen Punkt übertragene Leistung, die Temperatur, den Scheitelwert oder Effektivwert der Netzspannung, die Frequenz der Netzspannung, den an einem Punkt fließenden Strom, die Symmetrie der Belastung der einzelnen Phasen des Energieversorgungsnetzwerks und andere physikalische Größen bestimmen. Derartige Messgrößen ermöglichen weitere Rückschlüsse auf den Zustand des Energieversorgungsnetzwerks und sind in verschiedensten Ausgestaltungen aus der Praxis bekannt.

Ein erfindungsgemäßes Verfahren zur Überwachung des Zustands eines Energieversorgungsnetzwerks wird vorzugsweise im Zusammenhang mit dem erfindungsgemäßen System verwendet und dient vorzugsweise zur Detektion von Teilentladungen. Ähnlich wie bei dem erfindungsgemäßen Messknoten und dem erfindungsgemäßen System wird das erfindungsgemäße Verfahren im laufenden Betrieb des Energieversorgungsnetzwerks durchgeführt, wodurch am Energieversorgungsnetzwerk eine Netzspannung anliegt. In einem ersten Schritt des erfindungsgemäßen Verfahrens wird ein Störsignal aus dem Energieversorgungsnetzwerk ausgekoppelt, wobei hierzu ein Koppelnetzwerk verwendet wird. Die Auskopplung des Störsignals erfolgt bei einem von mehreren über ein geografisches Gebiet verteilten Messknoten, der nachfolgend als erster Messknoten bezeichnet wird. In einem nächsten Schritt wird aus dem Störsignal ein Messsignal erzeugt, wobei die Erzeugung des Messsignals bei dem ersten Messknoten im Wesentlichen durch Bandpassfilterung des Störsignals erfolgt. Das Messsignal wird derart gebildet, dass es zumindest eine für den Zustand des Energieversorgungsnetzwerks repräsentative Komponente enthält.

In einem nächsten Schritt wird das Messsignal über einen Auswertezeitraum hinweg analysiert, wobei der Auswertezeitraum einige Millisekunden, eine Periode der Netzspannung, mehrere oder eine Vielzahl von Perioden der Netzspannung oder anderweitig festgelegte Zeitspanne umfassen kann. Die Wahl des Auswertezeitraums hängt im Wesentlichen von den aus dem Messsignal zu extrahierenden Größen für den Zustand des Energieversorgungsnetzwerks ab. Bei der Bestimmung von Teilentladungen dürfte beispielsweise die Auswertung in mehreren Perioden der Netzspannung notwendig sein. Die Analyse des Messsignals erfolgt dabei unter Berücksichtigung des zeitlichen Verlaufs von zumindest Teilen des Messsignals relativ zu der Netzspannung. Dabei wird beispielsweise festgestellt, ob das Messsignal regelmäßig an einer ähnlichen Stelle der Periode der Netzspannung auftaucht, wodurch bei konstant vorhandenem Messsignal beispielsweise auf das Vorliegen von Teilentladungen geschlossen werden kann. In einem weiteren Schritt wird basierend auf dem Ergebnis der Analyse eine Bewertungsgröße für den Zustand eines mit dem Messknoten verbundenen Teilbereichs des Energieversorgungsnetzwerks bestimmt. Die Messsignale und/oder bestimmten Bewertungsgrößen werden in einem weiteren Schritt an einen Server übertragen, der über ein Weitbereichsnetzwerk mit dem Messknoten verbunden ist. Bei dem Server werden die empfangenen Messsignale und/oder Bewertungsgrößen abgespeichert. Es ist denkbar, dass die Erzeugung von Bewertungsgrößen bei einer Auswerteeinheit bei dem Server erfolgt. In diesem Fall kann die Reihenfolge der Schritte des Erzeugens der Bewertungsgröße und des Übermittelns der Messwerte an den Server vertauscht werden.

Wird das Energieversorgungsnetzwerk auf das Vorliegen von Teilentladungen überwacht, so kann die Bewertungsgröße angeben, in welchem Ausmaß TE vorliegen. Dabei kann die Intensität der Teilentladungen auch Rückschlüsse auf die Leistungsaufnahme und die Temperatur im Kabel zulassen, da bei höherem Stromfluss in einem Leiter mehr TE vorhanden sind.

Zum Erkennen von Teilentladungen kann ein Messsignal beispielsweise bei einer Frequenz von 1,9 MHz aus dem Störsignal herausgefiltert werden. Weist das Messsignal in einer Vielzahl von Perioden an annähernd der gleichen Stelle im Bezug auf die Periode der Netzspannung ein Peak auf, so besteht ein erstes Indiz für eine Teilentladung. Ist dieser Peak zu unterschiedlichen Zeiten eines Tages vorhanden, so erhärtet sich dieses Indiz. Wenn beispielsweise der Peak durch ein Wechselrichter einer Photovoltaik-Anlage erzeugt würde, so wäre der Peak spätestens mit Sonnenuntergang nicht mehr vorhanden. Auch bei einem Peak, der von einem Wechselrichter einer Windkraftanlage erzeugt würde, ist es unwahrscheinlich, dass dieser dauerhaft und unverändert vorhanden ist. Er dürfte zumindest in seiner Intensität erheblich schwanken. Im Ergebnis kann also zunächst eine Bewertungsgröße bestimmt werden, die für eine entsprechende TE spricht. Wenn in einer Langzeitanalyse dies bestätigt wird, kann als Ursache für die Bewertungsgröße eine TE verifiziert werden.

Über die Lage der Peaks, die auf TE schließen lassen, relativ zu der Periode der Netzspannung können Rückschlüsse auf die Art der TE gezogen werden. Es wurde festgestellt, dass unterschiedlich hervorgerufene TE zu Peaks in unterschiedlichen Quadranten der Netzspannung führt (mit 1. Quadrant: steigende positive Spannung, 2. Quadrant: fallende positive Spannung, 3. Quadrant fallende negative Spannung, 4. Quadrant: steigende negative Spannung). TE in einem Erdkabel führen zu Peaks in einem anderen Quadranten als TE in einer Kabelmuss.

Zur Bestimmung einer Bewertungsgröße aus dem Messsignal kann das Messsignal auch mit einer Referenzcharakteristik verglichen werden. Hierzu würde aus dem Messsignal ein Charakteristikum extrahiert, das durch Rückwirkung eines Betriebsmittels auf das Energieversorgungsnetzwerk hervorgerufen wird. Insbesondere aktive Betriebsmittel, wie beispielsweise Wechselrichter, erzeugen abhängig von ihrem Betriebszustand eine charakteristische Rückwirkung auf das Energieversorgungsnetzwerk. Werden diese Charakteristika extrahiert und mit Referenzcharakteristika verglichen, die Rückwirkungen einer Vielzahl von Betriebsmitteln in verschiedenen bekannten Betriebszuständen auf ein Energienetzwerk widerspiegeln, so kann aus der Ähnlichkeit einer extrahierten Charakteristik zu einem Referenzcharakteristikum auf den Betriebszustand eines Betriebsmittels geschlossen werden. Der Betriebszustand könnte dann als Bewertungsgröße ausgegeben werden. Vorzugsweise sind dabei die Referenzcharakteristika in einer Datenbank abgespeichert und sind für eine Vielzahl von verschiedenen Betriebsmitteln in unterschiedlichen Betriebszuständen aufgenommen worden. Dabei sollten die Extraktion des Charakteristikums aus dem Messsignal und die Extraktion des Referenzcharakteristikums auf die gleiche Art und Weise erfolgen.

Es gibt nun verschiedene Möglichkeiten, die Lehre der vorliegenden Erfindung in vorteilhafter Weise auszugestalten und weiterzubilden. Dazu ist einerseits auf die den Ansprüchen 1, 9 und 12 nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: eine schematische Darstellung eines erfindungsgemäßen Messknotens,
- Fig. 2: eine detailliertere Darstellung eines erfindungsgemäßen Messknotens,
- Fig. 3: eine schematische Darstellung eines erfindungsgemäßen Messknotens mit einem besonders ausgestalteten Koppelnetzwerk,
- Fig. 4: eine schematische Darstellung eines erfindungsgemäßen Systems mit einer Vielzahl erfindungsgemäßer Messknoten
- Fig. 5: eine andere schematische Darstellung eines erfindungsgemäßen Systems mit einer Vielzahl von erfindungsgemäßen Messknoten und
- Fig. 6: Eine schematische Darstellung von Leitungslängen zwischen mehreren Stationen zur Erläuterung der Lokalisierung von Teilentladungen.

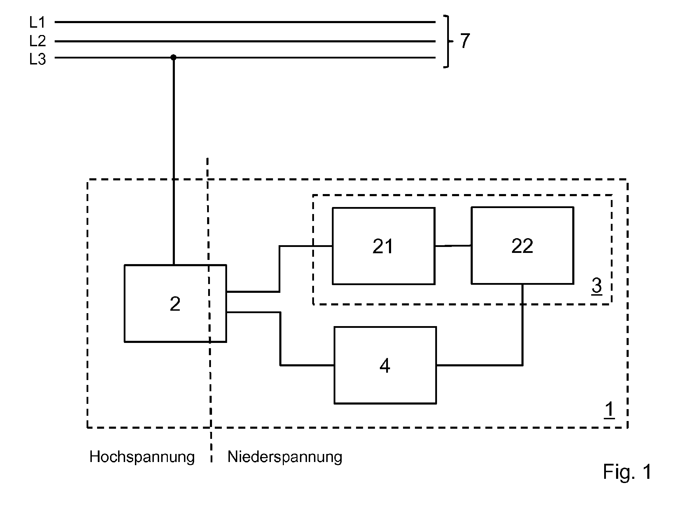

Fig. 1 zeigt eine schematische Darstellung eines erfindungsgemäßen Messknotens 1. Der Messknoten 1 umfasst ein Koppelnetzwerk 2, eine Detektorschaltung 3 und ein BPL-Modem 4. Das Koppelnetzwerk 2 ist mit einer Phase L3 eines dreiphasigen Energieversorgungsnetzwerks 7 verbunden und koppelt aus dem Energieversorgungsnetzwerk ein Störsignal aus. Das Störsignal befindet sich dabei auf Niederspannungsniveau, während der Anschluss und Teile des Koppelnetzwerks 4 auf Hochspannungsniveau (also über 1kV) liegt. Dies ist in Fig. 1 durch eine senkrechte gestrichelte Linie angedeutet.

Das mit dem Koppelnetzwerk 2 ausgekoppelte Störsignal wird der Detektorschaltung 3 zugeführt. Die Detektorschaltung 3 umfasst eine Filterschaltung 21 und eine Auswerteeinheit 21. Das in die Detektorschaltung 3 zugeführte Störsignal wird an die Filterschaltung weitergeleitet. Die Filterschaltung 3 erzeugt daraus durch Bandpassfilterung ein Messsignal, das an die Auswerteeinheit 22 zur Erzeugung einer Bewertungsgröße weitergeleitet wird. In der Filterschaltung 21 oder der Auswerteeinheit 22 erfolgt eine Digitalisierung des Messsignals, d.h. eine Zeit- und Wertdiskretisierung des analogen Messsignals. Das digitalisierte Messsignal und/oder die Bewertungsgröße werden danach an das BPL-Modem 4 übermittelt. Dort werden die empfangenen Daten in ein oder mehrere BPL-Datenpakete paketiert und mittels BPL-Signalen über das Koppelnetzwerk und das Energieversorgungsnetzwerk an einen entfernten Rechner übertragen.

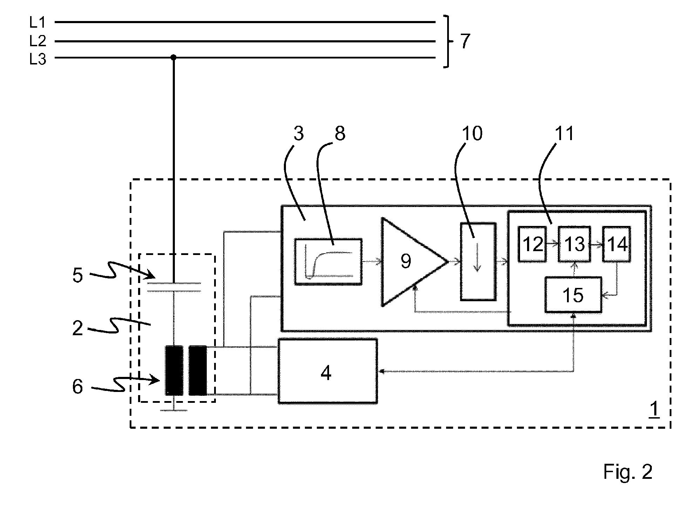

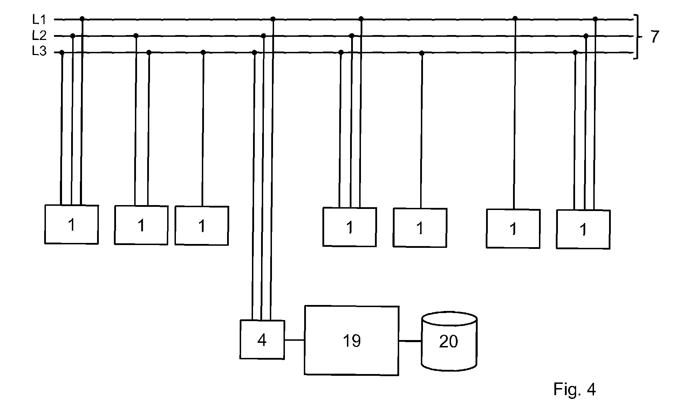

Fig. 2 zeigt eine detailliertere Ausgestaltung des Messknotens nach Fig. 1, wobei hier die Auswerteeinheit weitgehend in einen Server des Systems verschoben ist, was im Zusammenhang mit Fig. 4 noch näher beleuchtet wird. Der Messknoten 1 umfasst ein Koppelnetzwerk 2, eine Detektorschaltung 3 und ein BPL-Modem 4. Das Koppelnetzwerk 2 ist durch einen Koppelkondensator 5 und einen Transformator 6 ausgestaltet. Ein Anschluss des Koppelkondensators 5 ist mit einer Phase L3 des Energieversorgungsnetzwerks 7 verbunden, wobei das Energieversorgungsnetzwerk beispielhaft durch die drei Phasen eines Drehstrommittelspannungsnetzwerks dargestellt ist. Der zweite Anschluss des Koppelkondensators 5 ist mit einem Anschluss der Primärseite des Transformators 6 verbunden, während der zweite Anschluss der Primärwicklung des Transformators 6 auf Erdpotential gelegt ist. Koppelkondensator 5 und Primärwicklung des Transformators 6 sind also in Reihe geschaltet. Die Sekundärseite des Transformators 6 ist mit dem Eingang der Detektorschaltung 3 sowie mit dem BPL-Modem 4 verbunden. Der Koppelkondensator 5 sorgt dafür, dass die niederfrequente Netzspannung geblockt wird. Gleichzeitig werden die höherfrequente Störsignale, beispielsweise im Bereich von einigen kHz bis einigen MHz, aus dem Energieversorgungsnetzwerk ausgekoppelt werden. Der Transformator 6 sorgt für eine galvanische Entkopplung zwischen dem Energieversorgungsnetzwerk und der Detektorschaltung 3. Je nach Ausgestaltung kann der Transformator ein Übertragungsverhältnis von 1 aufweisen (also als Übertrager ausgestaltet sein) oder die ausgekoppelten Störanteile heruntertransformieren. Gleichzeitig koppelt das Koppelnetzwerk 2 BPL-Signale aus dem Energieversorgungsnetzwerk 7 aus und stellt diese dem BPL-Modem 4 zur Verfügung. Von dem BPL-Modem zu versendende BPL-Signale werden über den Transformator 6 und den Koppelkondensator 5 auf die Phase L3 des Energieversorgungsnetzwerks 7 gekoppelt.

Die Detektorschaltung 3 umfasst die Funktionen der Filterschaltung 21 sowie Teile der Auswerteeinheit 22, wobei die meisten Funktionen der Auswerteeinheit 22 - wie bereits angesprochen - in dieser Ausgestaltung auf den Server des Systems verschoben sind. Ein aus dem Energieversorgungsnetzwerk 7 ausgekoppeltes Störsignal, das am Eingang der Detektorschaltung 3 anliegt, wird zunächst mit einem Hochpass 8 gefiltert. Damit werden weitere niederfrequente Anteile des Störsignals herausgefiltert. Anschließend wird das hochpassgefilterte Signal einem Verstärker 9 zugeführt, der über ein AGC (Automatic Gain Control) verfügt und damit in seiner Verstärkung anpassbar ist. Das hochpassgefilterte und verstärkte Signal wird danach einem Frequenzreduzierer 10 zugeführt, der ein Downsampling des eingegebenen Signals durchführt. Dadurch wird das hochpassgefilterte und verstärkte Störsignal auf niedrigere Frequenzen herunter transformiert. Das derart hochpassgefilterte, verstärkte und frequenzreduzierte Signal wird in einen DSP (Digital Signal Processor) 11 eingegeben. In dem DSP 11 wird zunächst in Funktionsblock 12 eine diskrete Fourier-Transformation (DFFT, Discrete Fast Fourier Transform) durchgeführt. Dadurch wird das in den DSP 11 eingegebene Zeitsignal in seine Frequenzbestandteile zerlegt und in Form von einzelnen Koeffizienten ausgegeben. Das Fourier-transformierte Signal wird einer Auswahleinrichtung 13 zugeführt, d.h. die einzelnen Koeffizienten des Fourier-transformierten Eingangssignals in Funktionsblock 12 werden an die Auswahleinrichtung übergeben. Die Auswahleinrichtung wählt aus den Koeffizienten gemäß Auswahlvorgaben ein oder mehrere Koeffizienten aus und leitet diese an Funktionsblock 14 weiter. Die ausgewählten Koeffizienten werden dort für eine inverse Fourier-Transformation (IDFFT - Inverse DFFT) genutzt und damit in ein Zeitsignal umgewandelt. Das noch digitalisierte Signal, das in Form mehrere digitalisierter Messwerte vorliegt, wird an eine Steuereinheit 15 übergeben. Die Steuereinheit 15 weist einen Speicher auf, in dem digitalisierte Messwerte des Messsignals zwischengespeichert werden. Sobald eine bestimmte Anzahl von Messwerten angesammelt ist, werden diese gemeinsam an das BPL-Modem 4 übergeben, das diese in BPL-Datenpakete paketiert und über BPL-Signale an das Energieversorgungsnetzwerk 7 sendet. Die BPL-Signale werden von einem in Fig. 1 nicht eingezeichneten Server empfangen, an dem sie ausgewertet werden und der die Funktion der Auswerteeinheit des Messknotens weitgehend übernommen hat. Dadurch kann die in dem Messknoten bereitgestellte Rechenleistung auf ein Minimum reduziert werden. Es sei jedoch darauf hingewiesen, dass die Auswertung der Messsignale auch an dem Messknoten selbst erfolgen kann und die dadurch gewonnenen Bewertungsgrößen über das BPL-Modem und das Energieversorgungsnetzwerk an den Server gesendet werden können. Auf diese Weise wird die zu übertragende Datenmenge reduziert. Gleichzeitig muss jedoch an dem Messknoten eine deutlich höhere Rechenleistung zur Verfügung stehen.

Über das BPL-Modem 4 können auch Steuerparameter empfangen werden, die an die Steuereinheit 15 weitergeleitet werden. Basierend auf den Steuerparametern kann die Steuereinheit die Auswahleinrichtung 13 steuern, indem die Auswahlvorgaben verändert und damit die Auswahl der in Funktionsblock 14 eingegebenen Koeffizienten beeinflusst werden. Gleichzeitig kann die Steuereinheit 15 basierend auf den empfangenen Steuerparametern Einfluss auf den Verstärker 9 nehmen und beispielsweise den Sollausgangspegel des verstärkten Signals definieren. Fig. 2 ist auch zu entnehmen, dass die Steuereinheit in dem DSP 11 implementiert ist.

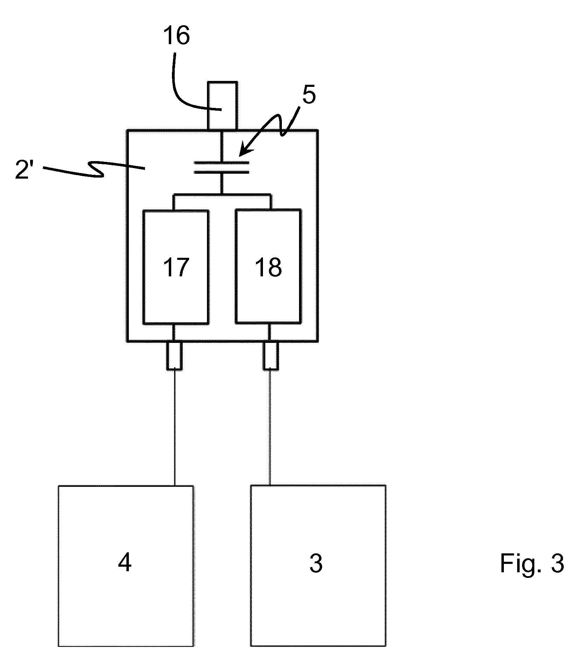

Fig. 3 zeigt eine schematische Darstellung eines erfindungsgemäßen Messknotens, bei dem ein besonders ausgestaltetes Koppelnetzwerk 2' verwendet ist. Das Koppelnetzwerk 2' weist einen Netzanschluss 16 auf, über den das Koppelnetzwerk 2' mit einer der Phasen eines Energieversorgungsnetzwerks 7 verbunden ist. Innerhalb des Koppelnetzwerks 2' ist mit dem Netzanschluss 16 ein Koppelkondensator 5 verbunden, dessen zweiter Anschluss mit einem der Anschlüsse einer ersten Koppelschaltung 17 und mit einem der Anschlüsse einer zweiten Koppelschaltung 18 verbunden ist. Der zweite Anschluss der ersten Koppelschaltung 17 ist mit einem BPL-Modem 4 des Messknotens 1 verbunden. Der zweite Anschluss der zweiten Koppelschaltung 18 ist mit der Detektorschaltung 3 entsprechend Fig. 2 verbunden. Die erste Koppelschaltung 17 ist dabei dazu ausgebildet, Breitband-Powerline-Signale zwischen dem Energieversorgungsnetzwerk 7 und dem BPL-Modem 4 auszutauschen. Die zweite Koppelschaltung 18 ist dabei dazu ausgebildet, Störsignale aus dem Energieversorgungsnetzwerk 7 auszukoppeln und für die Erzeugung eines Messsignals der Detektorschaltung 3 bereitzustellen. Weitere Details zu eines derartigen Koppelnetzwerks sind der deutschen Patentanmeldung 10 2013 221 150 der Anmelderin zu entnehmen.

Fig. 4 zeigt eine schematische Darstellung eines erfindungsgemäßen Systems, bei dem eine Vielzahl von Messknoten 1 jeweils mit einem Energieversorgungsnetzwerk 7 verbunden sind. In Fig. 4 sind beispielhaft sieben Messknoten dargestellt, wobei der Übersichtlichkeit wegen die Verteilung der verschiedenen Messknoten 1 auf ein geografisches Gebiet abstrahiert ist und die Messknoten 1 relativ nahe beieinander dargestellt sind. Die Messknoten 1 können prinzipiell zur Ankopplung an eine, zwei oder drei Phasen des Energieversorgungsnetzwerks 7 ausgebildet sein. Beispielhaft sind in Fig. 4 drei Messknoten zur Ankopplung an eine Phase des Energieversorgungsnetzwerks 7, ein Messknoten 1 zur Ankopplung an zwei Phasen und drei Messknoten 1 zur Ankopplung an drei Phasen dargestellt. Jeder Messknoten weist eine Detektorschaltung und ein BPL-Modem auf. Über das BPL-Modem kann der Messknoten 1 BPL-Signale mit einem BPL-Modem 4 austauschen, das mit einem Server 19 verbunden ist. Für die Verbindung zwischen BPL-Modem 4 und Server 19 kann beispielsweise ein Ethernet-Netzwerk zum Einsatz kommen. Der Server 19 ist zusätzlich mit einem Massenspeicher 20 verbunden, in dem Messwerte und/oder Bewertungsgrößen abgespeichert werden können.

Bei einer Ausgestaltung der Messknoten 1 wie im Zusammenhang mit Fig. 2 erläutert wird durch das Koppelnetzwerk eines Messknotens 1 zunächst ein Störsignal aus dem Energieversorgungsnetzwerk 7 ausgekoppelt. Aus dem Störsignal wird ein digitalisiertes Messsignal erzeugt, das über die Steuereinheit 15 und das BPL-Modem 4 in Form von BPL-Signalen in das Energieversorgungsnetzwerk 7 gesendet wird. Zusammen mit dem digitalisierten Messsignal kann auch ein Wert übermittelt werden, der Rückschlüsse auf die relative zeitliche Position des Messsignals zu der Netzspannung zulässt. Alternativ kann immer dann, wenn die Netzspannung einen Nulldurchgang hat, ein Netzsignalwert übermittelt werden, der bei einem positiven Wert einen Nulldurchgang mit steigender Spannung und bei negativem Wert einen Nulldurchgang mit sinkender Spannung annimmt. Sowohl Messwerte als auch Netzsignalwerte werden mit einem Zeitstempel versehen, der den Zeitpunkt der Erfassung des Wertes angibt. Insbesondere bei den Netzsignalwerten können auch mehrere Werte aggregiert werden. So können beispielsweise lediglich die Zeitstempel und die Polarität für mehrere, beispielsweise 100 Netzsignalwerte übertragen werden.

Die BPL-Signale werden durch das BPL-Modem 4 beim Server 19 empfangen, dort dekodiert und die dekodierten Messsignale mit den - wie auch immer gearteten - Bezügen zu der Periode der Netzspannung an Server 19 weitergeleitet. Server 19 speichert die empfangenen Messsignale auf dem Massenspeicher 20 ab. Gleichzeitig wird eine Analyse des Messsignals über einen Auswertezeitraum hinweg gestartet. Hierbei wird der zeitliche Verlauf von zumindest Teilen des Messsignals relativ zu der Netzspannung ausgewertet. Es wäre beispielsweise denkbar, Peaks des Messsignals zu detektieren und in Bezug zu der aktuellen Periode der Netzspannung zu setzen. Aus der Analyse des Messsignals würde der Server 19 dann eine Bewertungsgröße für den Zustand des mit dem Messknoten verbundenen Teilbereichs des Energieversorgungsnetzwerks berechnen und ebenfalls für den das Messsignal erzeugenden Messknoten auf dem Massenspeicher 20 ablegen. Je nach Ziel der Auswertung können die Messsignale danach gelöscht werden.

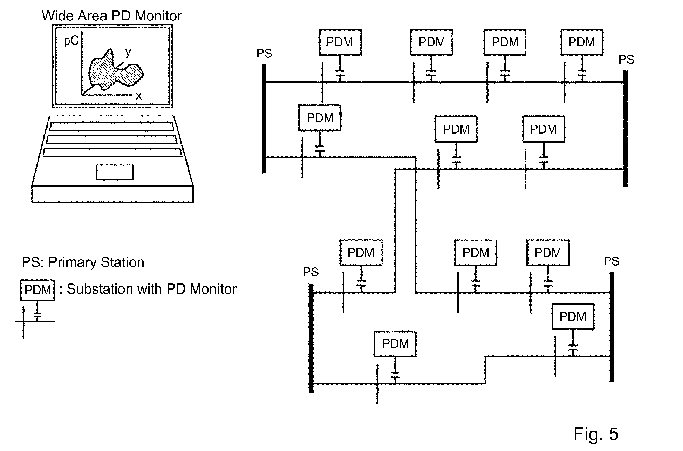

Fig. 5 zeigt eine andere schematische Darstellung einer Ausgestaltung eines erfindungsgemäßen Systems. Wenn alle Knoten oder zumindest sehr viele der Messknoten dazu ausgelegt sind, Teilentladungen zu messen, entsteht dadurch ein System zur Detektion von Teilentladungen auf einem größeren geografischen Gebiet. Dieses WAPDM (Wide Area Partial Discharge Monitor) ist in der Lage, Informationen über Teilentladungen in einem größeren geografischen Gebiet zu gewinnen. Das Energieversorgungsnetzwerk umfasst mehrere Primärstationen PS sowie mehrere Substationen, die schematisch durch kurze senkrechte Striche dargestellt sind. Die Verbindung zwischen den Primärstationen PS über die Substationen sind mit waagrechten Strichen dargestellt. Dabei sind zwei Teilstrecken untereinander mit einer Strecke verbunden, was durch eine senkrechte Verbindung dargestellt ist. An jeder Substation ist ein Messknoten PDM (Partial Discharge Monitor) angeordnet, der mit dem Energieversorgungsnetzwerk verbunden ist. Die Verbindung erfolgt über ein Koppelnetzwerk, das in Fig. 5 schematisch mit einem Kondensator dargestellt ist. Über die Auswertung der einzelnen Messknoten und Verwendung von historischen Werten ist eine zuverlässige Auswertung möglich.

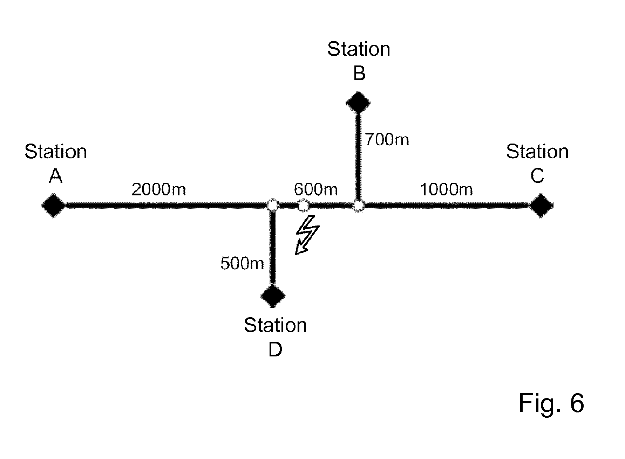

Fig. 6 zeigt Strecken eines Energieversorgungsnetzwerks sowie einzelne Abstände zwischen den Stationen A, B, C und D sowie Zwischenstationen. Wenn eine TE - beispielhaft mit einem Blitz dargestellt - erfolgt, werden breitbandig hochfrequente Störungen entstehen. Diese breiten sich über die Verbindungen des Energieversorgungsnetzwerks aus, wobei hohe Frequenzen nach relativ kurzen Wegen erheblich gedämpft sein werden. Da sich die Störungen nur mit begrenzter Geschwindigkeit in dem Energieversorgungsnetzwerk ausbreiten werden, wird zunächst die nächste Station D ein Störsignal empfangen, danach - sofern der Pegel noch nicht zu weit gedämpft ist - die Stationen B, C und A. Angenommen alle Stationen empfangen das Störsignal und erkennen das Vorliegen einer TE, dann kann durch Korrelation der Messergebnisse mit Kenntnis der Leitungslängen der Punkt bestimmt werden, an dem die TE stattgefunden hat.

Zusammenfassend können bei der vorliegenden Erfindung und deren Ausgestaltungen im Wesentlichen zwei Problemkreise berücksichtigt werden:
1. Technische und wirtschaftliche Umsetzung der Messung an einem Messknoten und
2. Auswertung der Ergebnisse einzelner Messknoten und der Abhängigkeit zu benachbarten Messknoten.

Nachfolgend werden diese Problemkreise und deren Lösung durch einzelne Ausgestaltungen der Erfindung beispielhaft anhand eines Mittelspannungsnetzes näher beleuchtet.

Zu 1.: Die Anbindung an das Mittelspannungsnetz erfolgt über einen kapazitiven Mittelspannungskoppler. Dessen Koppelnetzwerk stellt eine galvanische Trennung zwischen Mittelspannungsnetz und Messkreis her und ermöglicht so den Betrieb und Schutz des Messequipments. Mit einem geeigneten Messgerät werden die Signale verarbeitet, um TE Messwerte des einzelnen Messknotens zu erhalten.

Die Auswertesoftware bei den Messknoten setzt vorzugsweise folgende Dinge um:
- Speicherung der ermittelten TE-Werte pro Messknoten über die Zeit
- Auswertung der TE-Werte über Zeit und Ort
- Zeitliche und örtliche Korrelation der TE-Werte verschiedener Messknoten im betrachteten Netz bzw. Netzabschnitt
- Echtzeit-Analyse von TE-Werten und Hot Spot Betrachtung zur Fehlersuche
- Güteprognose der Infrastruktur
- Fernsteuerung der TE-Betrachtung und Messparameter

Das System hat sein größtes wirtschaftliches Potential in dicht besiedeltem Gebiet wie z.B. Stadtzentren oder großen Industrieanlagen. Prinzipiell kann die Technik auch in Hoch- und Höchstspannungsleitungen eingesetzt werden. Es wird lediglich ein anderer Messkondensator eingesetzt. Die Auswerteelektronik und -Software bleibt gleich.

Die Auswertequalität im laufenden Betrieb wird optimiert, indem bei einer Ringspeisung die offene Trennstelle des Mittelspannungsnetzes an einem Ende des zu messenden Kabels liegt oder je nach Betrachtung verschoben wird. Störeinflüsse durch defekte elektrische Geräte oder Kabelteile werden somit auch besser geortet. Ist das System in einem Mittelspannungsnetz mit fernsteuerbaren Mittelspannungsstationen installiert, kann die Leitwarte zusätzliche Messungen ohne negative Beeinflussung auf den Netzbetrieb und ohne zusätzlichen Personalaufwand durchführen.

Zu 2.: Die Kommunikation zwischen den einzelnen Messknoten und/oder dem zentralen Auswertungsserver kann entweder über ein parallel an den Koppler angeschlossenes Powerline-Modem oder über sonstige breitbandige Kommunikationsverbindungen realisiert werden. Die Auswertung und Überwachung der Messungen und die Speicherung der Zustände kann an einem zentralen Ort erfolgen, wie beispielsweise der Leitwarte.

Auf einzelne Messknoten kann in Echtzeit genauer und/oder verändert eingegangen werden. Testparameter und/oder Frequenzen können variiert werden. Je nach benötigter Genauigkeit und Frequenz der Messung wird der Datendurchsatz der Smart Grid Kommunikations-Infrastruktur belastet. Dies kann alternativ zur direkten zentralen Überwachung bzw. bei begrenzten Kommunikationsmöglichkeiten über eine Zwischenpufferung stattfinden. Die Auswertung kann im Messknoten selbst erfolgen. Die Auswertung kann über eine in der Nähe des Messknoten installierte Auswerteeinheit gesteuert werden.

Äußere Einflüsse auf das betrachtete Netz können mit den TE-Messungen festgestellt werden. So werden zum Beispiel mechanische oder elektrische Änderungen im Netz detektiert und so eventuelle Ursachen (z.B. defekte passive Bauelemente wie Muffen, defekte aktive Komponenten wie Wechselrichter oder äußere mechanische Einwirkungen wie Bagger) zeitnah ermittelt. Die Reaktionszeit auf Schäden wird durch die örtliche Bestimmung im Fehlerfall deutlich reduziert. Durch gleichzeitige Messung an mindestens zwei verschieden Messknoten ist eine Fehlerortung/ Lokalisation auch in Netzen möglich die Abgänge besitzen (siehe Fig. 6). Die Genauigkeit der TE-Fehlerlokalisierung ist derzeit auf ca. 0,2% der Kabellänge begrenzt. Durch Korrelation der Ergebnisse von mehreren Messknoten kann die Genauigkeit verbessert.

Andere Einflüsse, wie beispielsweise von Powerline-Kommunikationseinheiten oder anderen elektromagnetischen Beeinflussungen, sind möglich, da diese im Fehlerfall harmonische und Submodulationsprodukte erzeugen. Die TE auf Leitungen ist 50Hz synchron, andere Störungen sind stochastisch verteilt. Das Filterband wird beim Einbau des Messknotens geeignet ausgewählt und kann bei Fernwartung in Echtzeit angepasst werden. Des Weiteren können diese Rückschlüsse auf Leistungsaufnahme und Temperatur im Kabel zulassen, da bei höherem Stromdurchfluss im Leiter mehr Teilentladung vorhanden ist. Damit kann dem wesentlichen und beeinflussbaren Degrationseffekt der Überbelastung begegnet werden und Beschädigungen minimiert werden, indem aktiv z.B. PV-Anlagen abgeschaltet werden oder die Trennstelle im Ringbetrieb verschoben wird, um die Last zu verteilen.

In Kombination mit anderen Sensoren in der Station wie Leistungsmessgeräten ist eine umfangreiche und flächendeckende Betriebsüberwachung möglich.

Auf Besonderheiten bei verschiedenen Kabeltypen kann ebenfalls Rücksicht genommen werden. In 3-phasigen Öl-Papier/Massekabeln mit einem gemeinsamen Schirm findet ein Übersprechen von Signalen zwischen den Phasen statt. Die TE wird bei Monitoring nur einer einzelnen Phase zwar dann abgeschwächt erfasst, für die Beurteilung eines Kabelstrangs kann dies jedoch ausreichend sein.

Hinsichtlich weiterer vorteilhafter Ausgestaltungen des erfindungsgemäßen Messknotens, des erfindungsgemäßen Systems und des erfindungsgemäßen Verfahrens wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele des erfindungsgemäßen Messknotens, des erfindungsgemäßen Systems und des erfindungsgemäßen Verfahrens lediglich zur Erörterung der beanspruchten Lehre dienen, diese jedoch nicht auf die Ausführungsbeispiele einschränken.

### Bezugszeichenliste

- 1: Messknoten
- 2: Koppelnetzwerk
- 3: Detektorschaltung
- 4: BPL-Modem
- 5: Koppelkondensator
- 6: Transformator
- 7: Energieversorgungsnetzwerk
- 8: Hochpass
- 9: Verstärker mit AGC
- 10: Frequenzreduzierer
- 11: DSP
- 12: DFFT
- 13: Auswahleinrichtung
- 14: IDFFT
- 15: Steuereinheit
- 16: Netzanschluss
- 17: erste Koppelschaltung
- 18: zweite Koppelschaltung
- 19: Server
- 20: Massenspeicher
- 21: Filterschaltung
- 22: Auswerteeinheit

## Patentansprüche

1. Messknoten zur Überwachung des Zustands eines Teilbereichs eines Energieversorgungsnetzwerks, insbesondere zur Detektion von Teilentladungen, wobei an dem Energieversorgungsnetzwerk (7) eine Netzspannung anliegt, umfassend:
ein Koppelnetzwerk (2), das an das Energieversorgungsnetzwerk (7) ankoppelbar ist und das zum Auskoppeln eines Störsignals aus dem Energieversorgungsnetzwerk (7) ausgebildet ist,
eine Filterschaltung (21), die mit dem Koppelnetzwerk (2) verbunden ist und die durch Bandpassfilterung aus dem Störsignal ein Messsignal erzeugt, wobei der Bandpass derart dimensioniert ist, dass das Messsignal zumindest eine für den Zustand des Energieversorgungsnetzwerks (7) repräsentative Komponente enthält, und
eine Auswerteeinheit (22), die zur Analyse des Messsignals über einen Auswertezeitraum hinweg ausgebildet ist, wobei bei der Analyse der zeitliche Verlauf von zumindest Teilen des Messsignals relativ zu der Netzspannung ausgewertet wird und wobei die Analyse des Messsignals eine Bewertungsgröße für den Zustand des Teilbereichs des Energieversorgungsnetzwerks (7) liefert.

2. Messknoten nach Anspruch 1, **dadurch gekennzeichnet, dass** die Filterschaltung (3) einen Hochpassfilter (8), einen Verstärker (9), einen Analog/Digital-Wandler und einen Digitalen Signal Prozessor- DSP (11) - umfasst,
wobei der DSP (11) dazu ausgestaltet sein kann, eine Fourier-Transformation, insbesondere eine DFFT (Discrete Fast Fourier Transform), und eine inverse Fourier-Transformation, insbesondere eine IDFFT (Inverse DFFT) durchzuführen, und wobei dann in dem DSP (11) zusätzlich eine Auswahleinrichtung (13) ausgebildet ist, mit der ein oder mehrere Koeffizient/en eines Fourier-transformierten Eingangssignals ausgewählt und der inversen Fourier-Transformation zugeführt wird/ werden.

3. Messknoten nach Anspruch 1 oder 2, **dadurch gekennzeichnet, dass** der Messknoten (1) zum Ankoppeln an mehrere Phasen (L1, L2, L3) des Energieversorgungsnetzwerks (7) ausgebildet ist, wobei der Messknoten (7) für jede Phase (L1, L2, L3), an die der Messknoten (1) ankoppelbar ist, ein Koppelnetzwerk (2) und eine Filterschaltung (21) umfasst.

4. Messknoten nach einem der Ansprüche 1 bis 3, **dadurch gekennzeichnet, dass** das Koppelnetzwerk (2) einen Koppelkondensator (5) und/oder einen Transformator (6) umfasst, oder
dass das Koppelnetzwerk (2) einen Koppelkondensator (5), eine erste Koppelschaltung (17) und eine zweite Koppelschaltung (18) umfasst, wobei die ersten und die zweite Koppelschaltung (17, 18) mit ihrem netzseitigen Anschluss mit dem Koppelkondensator (5) verbunden sind und wobei die erste Koppelschaltung (17) zum Weiterleiten von Breitband-Powerline-Signalen - BPL-Signalen - zwischen dem Energieversorgungsnetzwerk (7) und einem BPL-Endgerät (4) und die zweite Koppelschaltung (18) zum Auskoppeln von Störsignalen zum Erzeugen eines Messsignals aus dem Energieversorgungsnetzwerk (7) ausgebildet sind.

5. Messknoten nach einem der Ansprüche 1 bis 4, **gekennzeichnet durch** ein Kommunikationsgerät zur Kommunikation über eine Weitbereichsschnittstelle, vorzugsweise ein BPL-Modem (4).

6. Messknoten nach einem der Ansprüche 1 bis 5, **dadurch gekennzeichnet, dass** die Filterschaltung (21) anpassbar ausgebildet ist, wobei vorzugsweise in der Filterschaltung (21) Mittenfrequenz und/oder Bandbreite der Bandpassfilterung anpassbar ausgebildet sind.

7. Messknoten nach einem der Ansprüche 1 bis 6, **dadurch gekennzeichnet, dass** der Messknoten (1) eine Uhr umfasst und dass mit Erzeugen eines Messsignals und/oder einer Bewertungsgröße ein Zeitpunkt auslesbar und als Zeitstempel für das Messsignal und/oder die Bewertungsgröße abspeicherbar ist.

8. Messknoten nach einem der Ansprüche 1 bis 7, **gekennzeichnet durch** eine Steuereinheit (15), die zum Empfangen von Steuerparametern für den Messknoten (1) und/oder zum Aufbereiten eines digitalisierten Messsignals ausgebildet ist.

9. System zur Überwachung des Zustands eines Energieversorgungsnetzwerks, insbesondere zur Detektion von Teilentladungen, wobei an dem Energieversorgungsnetzwerk (7) eine Netzspannung anliegt, umfassend:
mehrere Messknoten (1), vorzugsweise Messknoten nach einem der Ansprüche 1 bis 8, wobei die Messknoten (1) über ein geografisches Gebiet verteilt und jeweils zur Überwachung eines Teilbereichs des Energieversorgungsnetzwerks (7) mittels eines Koppelnetzwerks (2) mit dem Energieversorgungsnetzwerk (7) verbunden sind und wobei jeder Messknoten (1) aus Störsignalen, die über das Koppelnetzwerk (2) aus den Energieversorgungsnetzwerk (7) ausgekoppelt sind, ein Messsignal und/oder eine Bewertungsgröße für den Zustand des Teilbereichs des Energieversorgungsnetzwerks (7) bestimmt,
ein Weitbereichsnetzwerk zur Kommunikation mit den Messknoten (1),
ein Server (19), der über das Weitbereichsnetzwerk kommunizierend mit den Messknoten (1) verbunden ist, wobei der Server (19) dazu ausgebildet ist, digitalisierte Messsignale und/oder Bewertungsgrößen von den Messknoten (1) zu empfangen und abzuspeichern.

10. System nach Anspruch 9, **dadurch gekennzeichnet, dass** der Server (19) einen Massenspeicher (20) aufweist oder Zugriff auf einen Massenspeicher (20) hat, auf dem eine Vielzahl von digitalisierten Messsignalen und/oder eine Vielzahl von Bewertungsgrößen speicherbar sind, und dass der Server (19) dazu ausgebildet ist, über die in dem Massenspeicher (20) abgespeicherten Messsignale und/ oder Bewertungsgrößen eine Langzeitanalyse durchzuführen.

11. System nach Anspruch 9 oder 10, **dadurch gekennzeichnet, dass** in dem Server (19) eine Auswerteeinheit vorgesehen ist, die die Funktion der Auswerteeinheit für mehrere Messknoten des Systems übernimmt,
wobei die Auswerteeinheit derart ausgebildet sein kann, dass Messsignale von mehreren Messknoten (1) zur Bestimmung einer Bewertungsgröße kombiniert, vorzugsweise miteinander korreliert werden.

12. Verfahren zur Überwachung des Zustands eines Energieversorgungsnetzwerks, insbesondere zur Detektion von Teilentladungen, insbesondere unter Verwendung eines Systems nach einem der Ansprüche 9 bis 11, wobei an dem Energieversorgungsnetzwerk (7) eine Netzspannung anliegt, umfassend die Schritte:
Auskoppeln eines Störsignals aus dem Energieversorgungsnetzwerk (7) mittels eines Koppelnetzwerks (2) bei einem von mehreren über ein geografisches Gebiet verteilten Messknoten (1) - erster Messknoten,
Erzeugen eines Messsignals aus dem Störsignal bei dem ersten Messknoten (1) durch Bandpassfilterung, wobei das Messsignal derart gebildet wird, dass das Messsignal zumindest eine für den Zustand des Energieversorgungsnetzwerks (7) repräsentative Komponente enthält,
Analysieren des Messsignals über einen Auswertezeitraum hinweg, wobei der zeitliche Verlauf von zumindest Teilen des Messsignals relativ zu der Netzspannung ausgewertet wird,
Erzeugen einer Bewertungsgröße für den Zustand eines mit dem ersten Messknoten (1) verbundenen Teilbereichs des Energieversorgungsnetzwerks (7) basierend auf dem Ergebnis der Analyse und
Speichern der Messsignale und/oder Bewertungsgrößen bei einem Server (19), der über ein Weitbereichsnetzwerk mit den Messknoten (1) verbunden ist.

13. Verfahren nach Anspruch 12, **dadurch gekennzeichnet, dass** die Bewertungsgröße derart erzeugt wird, dass sie das Ausmaß einer Teilentladung, eine übertragene Leistung und/oder eine Temperatur kennzeichnet,
wobei bei einem Messsignal, das in einer Vielzahl aufeinander folgenden Perioden der Netzspannung mit im Wesentlichen konstantem Abstand zu einem Nulldurchgang der Netzspannung detektiert wird, auf das Vorliegen einer Teilentladung geschlossen wird, wobei aus dem Betrag des Messsignals vorzugsweise die Intensität der Teilentladung bestimmt wird und
wobei vorzugsweise aus der Häufigkeit von Teilentladungen und deren zeitlichen Verlauf auf den Zustand des Energieversorgungsnetzwerk oder zumindest eines Teils der Energieversorgungsnetzwerks (7) geschlossen wird.

14. Verfahren nach Anspruch 12 oder 13, **dadurch gekennzeichnet, dass** aus dem Messsignal ein Charakteristikum, das durch Rückwirkungen eines Betriebsmittel auf das Energieversorgungsnetzwerk hervorgerufen wird, extrahiert wird, dass das Charakteristikum mit mehreren Referenzcharakteristika aus einer Datenbank verglichen wird, wobei die Referenzcharakteristika die Rückwirkung einer Vielzahl von Betriebsmitteln auf ein Energieversorgungsnetzwerk in verschiedenen Betriebszuständen wiederspiegelt, und dass aus dem Ergebnis des Vergleichs auf den Betriebszustand des Betriebsmittels geschlossen wird.

15. Verfahren nach einem der Ansprüche 12 bis 14, **dadurch gekennzeichnet, dass** bei einem Energieversorgungsnetzwerk (7) mit Ringspeisung, bei dem eine offene Trennstelle für zwei in der Ringspeisung gebildeten Versorgungszweige ausgebildet ist, die offene Trennstelle während mehrerer, vorzugsweise aufeinander folgenden Messungen verschoben wird.
